# EUROPEAN PATENT APPLICATION

(11) **EP 2 492 953 A2**
(43) Date of publication of application: **29.08.2012**
(21) Application number: 11167419.8
(22) Date of filing: 25.05.2011
(51) Int. Cl.: H01L 21/02, H01L 21/20

(54) **Nitride based light emitting device using patterned lattice buffer layer and method of manufacturing the same**

(30) Priority: 28.02.2011 KR 20110018228
(71) Applicant: Semimaterials Co., Ltd., Sengnam-si, Gyeonggi-do 463-400 (KR); Park, Kun, Bundang-gu Sengnam-si, Gyeonggi-do 463-440 (KR)
(72) Inventor: Park, Kun, Gyeonggi-do 463-440 (KR); Jin, Joo, Gyeonggi-do 449-853 (KR)
(74) Representative: Müller Schupfner & Partner

(57) **Abstract**

Disclosed is a method of manufacturing a nitride-based light emitting device, in which a patterned lattice buffer layer is formed to minimize dislocation density upon growth of a nitride layer and an air gap is formed to enhance brightness of the light emitting device. The method includes depositing a material having a Wurtzite lattice structure on a substrate to form a deposition layer, forming an etching pattern on a surface of the deposition layer to form a patterned lattice buffer layer, and growing a nitride layer on the patterned lattice buffer layer. During the growth of the nitride layer, the patterned lattice buffer layer is removed to form an air gap at a portion of the nitride layer from which the patterned lattice buffer layer is removed. A nitride-based light emitting device manufactured thereby is also disclosed.

## Description

### 1. Technical Field

The present invention relates to a technique for manufacturing nitride-based light emitting devices.

### 2. Description of the Related Art

A light emitting device is a semiconductor device based on a luminescence phenomenon occurring upon recombination of electrons and holes in the device.

For example, nitride-based light emitting devices such as GaN light emitting devices are widely used. The nitride-based light emitting devices can realize a variety of colors due to high band-gap energy thereof. Further, the nitride-based light emitting devices exhibit excellent thermal stability.

The nitride-based light emitting devices may be classified into a lateral type and a vertical type according to arrangement of an n-electrode and a p-electrode therein. The lateral type structure generally has a top-top arrangement of the n-electrode and the p-electrode and the vertical type structure generally has a topbottom arrangement of the n-electrode and the p-electrode.

### BRIEF SUMMARY

One aspect of the present invention is to provide a method of manufacturing a nitride-based light emitting device, in which a patterned lattice buffer layer is formed to minimize occurrence of dislocations upon growth of a nitride layer and an air gap is formed to enhance brightness of the light emitting device.

Another aspect of the present invention is to provide a nitride-based light emitting device which includes a patterned lattice buffer layer to enhance crystallinity of a nitride and brightness of the light emitting device.

In accordance with one aspect of the invention, a method of manufacturing a nitride-based light emitting device includes: depositing a material having a Wurtzite lattice structure on a substrate to form a deposition layer; forming an etching pattern on a surface of the deposition layer to form a patterned lattice buffer layer; and growing a nitride layer on the patterned lattice buffer layer, wherein the growing a nitride layer includes removing the patterned lattice buffer layer to form an air gap at a portion of the nitride layer from which the patterned lattice buffer layer is removed.

The deposition layer may be formed of ZnO.

The patterned lattice buffer layer may be formed by photolithography and etching.

In accordance with another aspect of the invention, a nitride-based light emitting device includes: a substrate; a buffer layer formed on the substrate; and a light emitting structure formed on the buffer layer and having a plurality of nitride layers stacked thereon. Here, an air gap is formed between the substrate and the buffer layer.

### BRIEF DESCRIPTION OF THE DRAWINGS

The above and other aspects, features, and advantages of the invention will become apparent from the detailed description of the following embodiments in conjunction with the accompanying drawings:
Fig. 1 is a schematic flowchart of a method of manufacturing a nitride-based light emitting device using a patterned lattice buffer layer according to an exemplary embodiment of the present invention;
Fig. 2 is a sectional view of one example of a deposition layer having a Wurtzite lattice structure formed on a substrate in the method according to the embodiment of the present invention;
Fig. 3 is a sectional view of one example of a photoresist deposited on the deposition layer in the method according to the embodiment of the present invention;
Fig. 4 is a sectional view of one example of a photoresist pattern in the method according to the embodiment of the present invention;
Fig. 5 is a sectional view of one example of the deposition layer subjected to etching in the method according to the embodiment of the present invention;
Fig. 6 is a sectional view of one example of a patterned lattice buffer layer, which is formed by removing the photoresist pattern in the method according to the embodiment of the present invention;
Fig. 7 is a sectional view of one example of an air gap formed during growth of a nitride layer on the patterned lattice buffer layer in the method according to the embodiment of the present invention;
Fig. 8 is a sectional view of a nitride-based light emitting device using a patterned lattice buffer layer according to one exemplary embodiment of the present invention; and
Fig. 9 is a sectional view of a nitride-based light emitting device using a patterned lattice buffer layer according to another exemplary embodiment of the present invention.

### DETAILED DESCRIPTION

Exemplary embodiments of the invention will now be described in detail with reference to the accompanying drawings.

It will be understood that when an element such as a layer, film, region or substrate is referred to as being "on" another element, it can be directly on the other element or intervening elements may also be present. In contrast, when an element is referred to as being "directly on" another element, there are no intervening elements present.

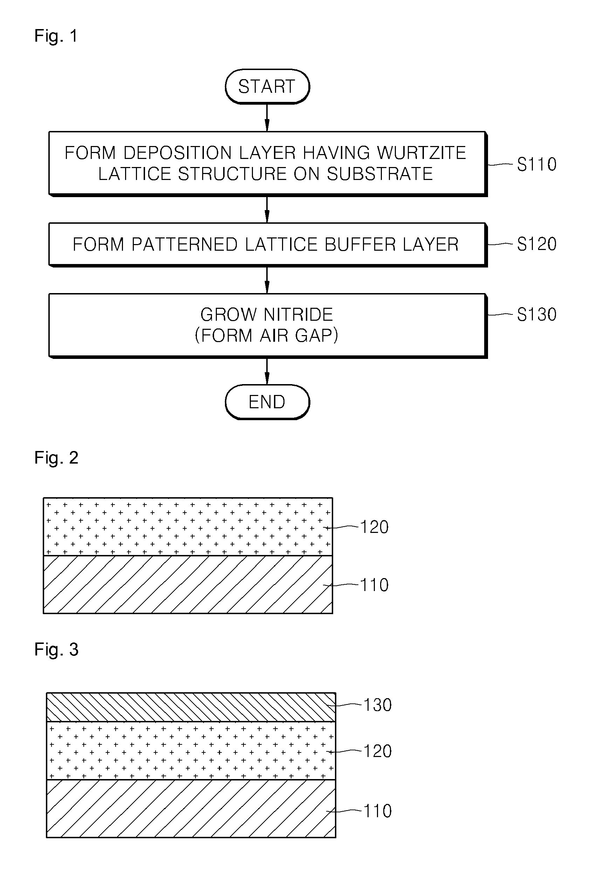

Fig. 1 is a schematic flowchart of a method of manufacturing a nitride-based light emitting device using a patterned lattice buffer layer according to an exemplary embodiment of the present invention.

Referring to Fig. 1, the method of manufacturing a nitride-based light emitting device includes forming a deposition layer in operation S10, forming a patterned lattice buffer layer in operation S20, and growing a nitride layer in operation S30.

First, as shown in Fig. 2, in operation S10, a material capable of forming a lattice buffer layer is deposited on a substrate 110 to form a deposition layer 120.

In this embodiment, the substrate 110 may be any substrate, for example, a sapphire substrate or a silicon substrate, which is widely used as a growth substrate in manufacture of nitride-based light emitting devices.

The deposition layer 120 may be formed by metal organic chemical vapor deposition (MOCVD). Alternatively, the deposition layer 120 may be formed by sputtering. When the deposition layer is formed by MOCVD, it is possible to improve the quality of the deposition layer. On the other hand, when the deposition layer is formed by sputtering, it is possible to increase a growth rate of the deposition layer.

The material for the lattice buffer layer may have a Wurtzite lattice structure.

In general, nitrides used for light emitting devices are GaN which has the Wurtzite lattice structure. Accordingly, when the lattice buffer layer has the Wurtzite lattice structure, lattice mismatch between the substrate and the nitride layer can be relieved.

When there is a large difference in lattice constant between the substrate and the nitride, dislocation defects in the nitride layer grown on the substrate increase to a great extent. As dislocation density increases, crystallinity of the nitride layer is lowered, thereby causing deterioration in brightness of the light emitting device.

Accordingly, when lattice mismatch is relieved, dislocation density decreases during growth of the nitride layer. As a result, the manufactured light emitting device has improved crystallinity and brightness.

ZnO may be used as a material having a Wurtzite lattice structure. ZnO has a Wurtzite lattice structure like GaN. Further, ZnO has lattice constants of a=3.249Å and c=5.207Å, which are similar to the lattice constants of GaN (a=3.189Å and c=5.185Å).

Thus, when growing GaN on ZnO, lattice match can be obtained, thereby minimizing dislocation density in a GaN layer during growth of the GaN layer.

ZnO can be etched in a hydrogen atmosphere. Accordingly, it is desirable that deposition of ZnO be carried out in an inert gas atmosphere such as nitrogen gas, argon gas, helium gas, and the like, instead of the hydrogen atmosphere. Further, it is known in the art that a nitride layer grown in the hydrogen atmosphere has better crystal quality than in any other atmosphere. However, when grown in the hydrogen atmosphere, the lattice buffer layer formed of ZnO can be etched by hydrogen gas.

Advantageously, a first nitride layer such as a buffer layer may be grown in the inert gas atmosphere and additional nitride layers may be formed in the hydrogen atmosphere.

Next, in operation S20, an etching pattern is formed on the surface of the deposition layer to form a patterned lattice buffer layer.

The patterned lattice buffer layer may be formed by photolithography and etching. Fig. 3 to Fig. 6 shows an example of forming a patterned lattice buffer layer through photolithography and etching.

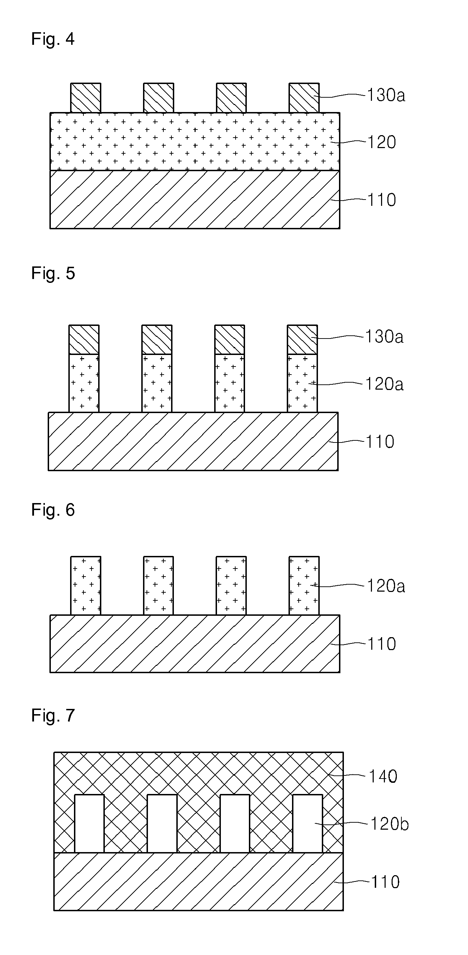

First, as shown in Fig. 3, a photoresist 130 is deposited on the deposition layer 120. Then, as shown in Fig. 4, the photoresist 130 is subjected to exposure and development to form a photoresist pattern 130a.

Then, as shown in Fig. 5, a region on the deposition layer 120 exposed by the photoresist pattern 130a is etched to form a patterned deposition layer 120a. The patterned deposition layer 120a becomes a patterned lattice buffer layer of the present invention.

Then, as shown in Fig. 6, the remaining photoresist is removed. Removal of the photoresist may be performed using acetone, methanol, and the like, and may include a DI rinsing process using de-ionized water.

Next, in operation S30, a nitride layer 140, for example a GaN layer, is grown on the patterned lattice buffer layer 120a (Fig. 6). The nitride layer such as the GaN layer can be grown at a low dislocation density by the lattice buffer layer 120a, which has a Wurtzite lattice structure.

At this time, during growth of the nitride layer, the patterned lattice buffer layer 120a is removed to form an air gap 120b, as shown in Fig. 7. The lattice buffer layer 120a may be completely or partially removed in this operation. The air gap 150 serves as an irregular reflection layer, thereby improving brightness of the nitride-based light emitting device

To form the air gap 120b, the nitride layer may be grown in a hydrogen atmosphere. For example, ZnO is likely to be etched by hydrogen gas. Accordingly, when the lattice buffer layer 120a is formed of ZnO and the nitride layer is grown in the hydrogen atmosphere, the air gap can be easily formed by ZnO etching during growth of the nitride layer.

Of course, when using hydrogen gas at an initial stage of growing the nitride layer, it is difficult to obtain lattice relieving effects at the initial stage of nitride growth due to etching of the lattice buffer layer, so that dislocation density increases in the growing nitride layer. Accordingly, the nitride layer is advantageously grown using nitrogen gas at the initial stage of nitride growth to ensure lattice relieving effects, and hydrogen gas is then used to remove the lattice buffer layer composed of ZnO or the like.

The nitride-based light emitting device manufactured by the process shown in Fig. 2 to Fig. 7 includes a substrate, an air gap, and a nitride-based light emitting structure. The nitride-based light emitting structure may be formed by stacking a plurality of nitride layers on the substrate.

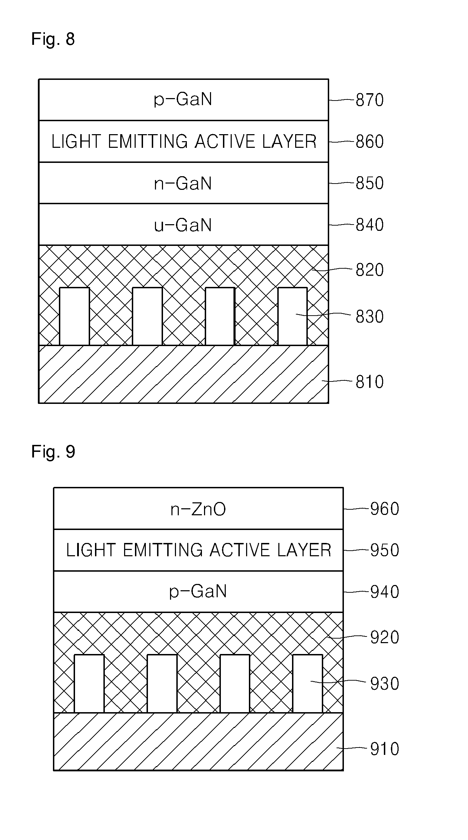

Fig. 8 is a sectional view of a nitride-based light emitting device using a patterned lattice buffer layer according to one exemplary embodiment of the present invention.

Referring to Fig. 8, the nitride-based light emitting device includes a substrate 810, a buffer layer 820, an undoped nitride layer 840, an n-type nitride layer 850, a light emitting active layer 860, and a p-type nitride layer 870.

In the embodiment of Fig. 8, an air gap 830 is formed between the substrate 810 and the buffer layer 820. As described above, the air gap 830 may be formed through removal of the patterned lattice buffer layer.

In the embodiment of Fig. 8, the buffer layer 820 may be formed of a nitride such as AIN, ZrN, GaN, and the like.

Next, the undoped nitride layer 840 may be formed on the buffer layer 820 to facilitate lattice matching. The undoped nitride layer 840 may be omitted as needed. If the substrate 810 is an undoped silicon substrate or a sapphire substrate, the undoped nitride layer may be used.

Next, the n-type nitride layer 850 is formed on the undoped nitride layer 840. if the undoped nitride layer 840 is not formed, the n-type nitride layer 850 is formed on the buffer layer 820. The n-type nitride layer 850 is formed by doping n-type impurities such as silicon (Si) to exhibit electrical characteristics of an n-type nitride layer.

Next, the light emitting active layer 860 is formed on the n-type nitride layer 850. The light emitting active layer 860 may have a multiple quantum well (MQW) structure. For example, the light emitting active layer 860 may have a structure having InₓGa₁₋ₓN (0.1≤x≤0.3) and GaN alternately stacked one above another.

Then, the p-type nitride layer 870 is formed on the light emitting active layer 860 and exhibits opposite electrical characteristics to those of the n-type nitride layer 132. To this end, the p-type GaN layer 870 may be formed by doping p-type impurities such as Mg or the like into a GaN layer.

In the embodiment of Fig. 8, an n-type silicon substrate may be adopted as the substrate 810. When the n-type silicon substrate is adopted, n-type semiconductor layers may be formed as the respective layers under the light emitting active layer 860. In addition, when the n-type silicon substrate is adopted, the silicon substrate may be used as an n-electrode. Thus, it is possible to eliminate a lift-off process for removing the growth substrate and a process of forming an n-electrode even in manufacture of a vertical type light emitting device.

Accordingly, when adopting the n-type silicon substrate, it is possible to easily fabricate not only a lateral type light emitting device but also the vertical type light emitting device which has a relatively wide light emitting area.

In addition, when the n-type silicon substrate is used as the substrate 810, the substrate is subjected to insignificant bowing during nitride growth at high temperature, thereby enabling uniform growth of the nitride layer at high temperature.

The buffer layer 820 may also be an n-type nitride layer. Nitrides for the buffer layer 820 generally have high electric resistance. However, if the buffer layer 820 is the n-type buffer layer, the buffer layer has low electric resistance.

Further, if an n-type silicon substrate is used as the substrate 810 and the buffer layer 820 is an n-type buffer layer, electrons injected into the n-type silicon substrate can easily reach the light emitting active layer 870 without interference of a barrier. Accordingly, it is possible to further improve operational efficiency of the light emitting device.

Fig. 9 is a sectional view of a nitride-based light emitting device using a patterned lattice buffer layer according to another exemplary embodiment of the present invention.

Referring to Fig. 9, the nitride-based light emitting device includes a substrate 910, a buffer layer 920, a p-type nitride layer 940, a light emitting active layer 950, and an n-type ZnO layer 960.

In the embodiment of Fig. 9, an air gap 930 is formed between the substrate 910 and the buffer layer 920. As described above, the air gap 930 may be formed through removal of the patterned lattice buffer layer.

In the embodiment of Fig. 9, the substrate 910, buffer layer 920, air gap 930 and respective layers of the light emitting structure are the same as those of the above embodiment, and detailed descriptions thereof will thus be omitted herein.

Referring to Fig. 9, the p-type nitride layer 940 is first formed on the substrate 910, and the light emitting active layer 950 is then formed on the p-type nitride layer 940.

Conventionally, in the method of manufacturing a nitride-based light emitting device, the p-type nitride layer is formed at the last stage after the light emitting active layer is formed. Here, the p-type nitride layer is grown at a lower growth temperature to suppress influence of the p-type impurity on the light emitting active layer during formation of the p-type nitride layer. As a result, crystal quality of the p-type nitride layer is deteriorated, causing deterioration of light emitting efficiency.

In this embodiment, however, the p-type nitride layer 940 is formed before the light emitting active layer 950, thereby ensuring high crystal quality of the p-type nitride layer.

The n-type ZnO layer 960 is formed on the light emitting active layer 950 and exhibits opposite electrical characteristics, that is, n-type electrical characteristics, to those of the p-type nitride layer 940. The n-type ZnO layer 960 may be formed by doping n-type impurities such as silicon (Si) into a ZnO layer.

As described above, ZnO has a Wurtzite lattice structure that is substantially the same as that of GaN. In addition, since ZnO can be grown even at a temperature of about 700∼800°C, it is possible to improve crystal quality by minimizing influence on the light emitting active 950 during growth of ZnO. Thus, the n-type ZnO layer 960 applicable to the present invention can replace n-type GaN, which is grown at high temperature of about 1200°C.

Further, in the embodiment of Fig. 9, a p-type silicon substrate may be adopted as the substrate 910. When the p-type silicon substrate is adopted, p-type layers may be formed as the respective layers under the light emitting active layer 950. Further, when the p-type silicon substrate is adopted as the substrate 910, the silicon substrate may act as a p-electrode. Here, the buffer layer 920 may also be formed of a p-type layer.

On the other hand, when the buffer layer 920 is a p-type buffer layer, impurities such as magnesium (Mg) in the buffer layer 920 diffuse into the growth substrate 910. In this case, the substrate 910 exhibits electrical characteristics of the p-type layer. Thus, even if a sapphire substrate having insulation characteristics is used as the substrate 910, there is no need for removal of the sapphire substrate, unlike in manufacture of conventional vertical type light emitting devices.

As set forth above, in the method of manufacturing a nitride-based light emitting device according to the embodiments, a patterned lattice buffer layer having a Wurtzite lattice structure is used. As a result, it is possible to decrease dislocation density caused by differences in lattice constant during growth of a nitride layer. Further, in this method, an air gap is formed during growth of the nitride layer. Accordingly, the method according to the embodiments may improve brightness of the nitride-based light emitting device manufactured thereby.

As such, according to the embodiments of the invention, a lattice buffer layer having a Wurtzite lattice structure and a surface pattern is used in the method of manufacturing a nitride-based light emitting device. As a result, the method can decrease dislocation density and form an air gap during growth of a nitride layer.

Accordingly, the nitride-based light emitting device manufactured by the method may have excellent crystallinity and exhibits improved brightness by the air gap.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A nitride-based light emitting device including a buffer layer and a light emitting structure on a substrate, **characterized by** comprising:
a substrate;
a buffer layer formed on the substrate; and
a light emitting structure formed on the buffer layer and having a plurality of nitride layers stacked thereon,
wherein an air gap is formed between the substrate and the buffer layer.

2. The nitride-based light emitting device of claim 1, **characterized in that** the light emitting structure comprises:
an n-type nitride layer formed on the buffer layer;
a light emitting active layer formed on the n-type nitride layer; and
a p-type nitride layer formed on the light emitting active layer.

3. The nitride-based light emitting device of claim 2, **characterized in that** the substrate is an n-type silicon substrate.

4. The nitride-based light emitting device of claim 3, **characterized in that** the buffer layer is an n-type buffer layer.

5. The nitride-based light emitting device of claim 1, **characterized in that** the light emitting structure comprises:
a p-type nitride layer formed on the buffer layer;
a light emitting active layer formed on the p-type nitride layer; and
an n-type ZnO layer formed on the light emitting active layer.

6. The nitride-based light emitting device of claim 5, **characterized in that** the substrate is a p-type silicon substrate.

7. The nitride-based light emitting device of claim 6, **characterized in that** the buffer layer is a p-type buffer layer.

8. A method of manufacturing a nitride-based light emitting device including a buffer layer and a light emitting structure on a substrate, **characterized by** comprising:
depositing a material having a Wurtzite lattice structure on a substrate to form a deposition layer;
forming an etching pattern on a surface of the deposition layer to form a patterned lattice buffer layer; and
growing nitride layers on the patterned lattice buffer layer to form a buffer layer and a light emitting structure,
wherein the growing the nitride layers comprises removing the patterned lattice buffer layer to form an air gap at a portion of the nitride layers from which the patterned lattice buffer layer is removed.

9. The method of claim 8, **characterized in that** the deposition layer is formed of ZnO.

10. The method of claim 9, **characterized in that** the deposition layer is formed by MOCVD.

11. The method of claim 9, **characterized in that** the deposition layer is formed by sputtering.

12. The method of claim 9, **characterized in that** the growing the nitride layers is first performed in a nitrogen atmosphere and is then performed in a hydrogen atmosphere.

13. The method of claim 8, **characterized in that** the substrate is a silicon substrate or a sapphire substrate.

14. The method of claim 8, **characterized in that** the patterned lattice buffer layer is formed by photolithography and etching.
